# FASCICULE DE BREVET EUROPEEN

(11) **EP 0 782 228 B1**
(45) Date de publication et mention de la délivrance du brevet: **17.02.1999**
(21) Numéro de dépôt: 96402874.0
(22) Date de dépôt: 24.12.1996
(51) Int. Cl.: H01S 3/085

(54) **Procédé de fabrication d'un laser semi-conducteur à émission par la surface**
Herstellungsverfahren für einen oberflächenemittierenden Laser
Method for manufacturing a surface emitting laser

(30) Priorité: 27.12.1995 FR 9515544
(43) Date de publication de la demande: 02.07.1997
(73) Titulaire: ALCATEL ALSTHOM COMPAGNIE GENERALE D'ELECTRICITE, 75382 Paris Cédex 08 (FR)
(72) Inventeur: Brillouet, François, 92140 Clamart (FR); Jacquet, Joel, 91470 Limours (FR); Plais, Antonia, 75019 Paris (FR); Goldstein, Léon, 92370 Chaville (FR); Salet, Paul, 92140 Clamart (FR)
(74) Mandataire: Fournier, Michel Robert Marie

(56) Documents cités:
- ELECTRONICS LETTERS, vol. 31, no. 11, 25 Mai 1995, pages 886-888, XP000519105 YANG G M ET AL: "ULTRALOW THRESHOLD CURRENT VERTICAL-CAVITY SURFACE-EMITTING LASERS OBTAINED WITH SELECTIVE OXIDATION"
- APPLIED PHYSICS LETTERS, vol. 65, no. 1, 4 Juillet 1994, pages 97-99, XP000458753 HUFFAKER D L ET AL: "NATIVE-OXIDE DEFINED RING CONTACT FOR LOW THRESHOLD VERTICAL-CAVITY LASERS"
- COMPOUND SEMICONDUCTORS 1994, SAN DIEGO, SEPT. 18 - 22, 1994, no. PROC. 21, 18 Septembre 1994, GORONKIN H;UMESH MISHRA (EDS ), pages 563-566, XP000509710 ROCHUS S ET AL: "VERTICAL-CAVITY SURFACE-EMITTING LASERS WITH BURIED LATERAL CURRENT CONFINEMENT"

## Description

L'invention concerne une catégorie de lasers semi-conducteurs appelés "lasers à émission par la surface" ou "VCSEL" (de l'anglais : "Vertical cavity surface emitting laser").

Ces lasers sont réalisés à partir d'un substrat semi-conducteur composé d'éléments de type III-V tels que l'arséniure de gallium GaAs ou le phosphure d'indium InP.

Contrairement aux lasers semi-conducteurs classiques, l'émission de lumière s'effectue perpendiculairement à la surface de la couche active et dans la même direction que l'injection du courant électrique entretenant l'effet laser. Le composant est essentiellement constitué d'une cavité résonnante contenant la couche active et délimitée par deux miroirs diélectriques ou semi-conducteurs opposés. Dans le cas par exemple d'un substrat InP, la cavité résonnante est formée d'une couche d'InP dopé p, d'une couche active et d'une couche InP dopé n. L'injection de courant s'effectue par l'intermédiaire de deux électrodes disposées de part et d'autre de la cavité résonnante. L'une au moins de ces électrodes est généralement placée à côté ou, le plus souvent autour du miroir qui est situé sur la même face. Un bon rendement pour une telle structure est conditionné par un confinement suffisant de la partie active aussi bien du point de vue optique qu'électrique.

Pour obtenir un bon confinement électrique et optique, une première solution consiste à utiliser une structure où la couche active est enterrée dans un milieu possédant un plus faible indice de réfraction. Si la couche active bonne conductrice est de plus enterrée dans un milieu p à la frontière du milieu n, on obtiendra également un confinement électrique dû à la tension de seuil de la jonction p-n qui entoure la couche active. Pour réaliser cette structure, on est conduit à former par gravure latérale un mésa assez haut contenant la partie de couche active que l'on veut enterrer. Il faut ensuite effectuer plusieurs reprises d'épitaxie de substrat dopé n puis de substrat p. Outre sa complexité, cette solution présente l'inconvénient d'un défaut de planéité au-dessus du mésa, c'est-à-dire à l'endroit où doit être formé l'un des miroirs.

Une autre solution peut consister à réaliser par gravure un mésa suffisamment surélevé pour dégager latéralement la périphérie de la couche active. Une gravure latérale de cette couche active permet alors d'obtenir le confinement désiré. Cette solution résout le problème de planéité de la surface mais pose par contre un problème de recombinaison de porteurs au voisinage de l'interface entre la couche active et l'air.

Une autre solution est décrite dans l'article "Ultralow threshold current vertical-cavity surface-emitting lasers obtained with selective oxidation", G.M. Yang, et al, ELECTRONICS LETTERS, 25 Mai 1995, Vol.31, No.11. La structure proposée comporte une couche active non enterrée au-dessus de laquelle est placée une couche de confinement de courant. Cette couche est réalisée à partir d'une couche continue d'arséniure d'aluminium à laquelle on fait subir une oxydation latérale contrôlée de façon à laisser une ouverture de courant située en dessous du miroir supérieur. Cette solution assure une bonne planéité de la surface recevant le miroir mais exige un contrôle délicat de l'étape d'oxydation latérale. Il est par ailleurs nécessaire de déposer ensuite une couche de protection en nitrure de silicium pour arrêter l'oxydation de la couche d'arséniure d'aluminium.

L'invention a pour but d'éviter les inconvénients des solutions précédentes en proposant un procédé facile à mettre en oeuvre et applicable quelle que soit la composition du substrat.

Dans ce but, l'invention a pour objet un procédé de fabrication d'un laser semi-conducteur à émission par la surface formé sur un substrat d'éléments III-V, ledit laser comportant une cavité résonnante délimitée par des miroirs et contenant une couche active ainsi qu'une couche de confinement électrique, caractérisé en ce que la formation de ladite couche de confinement électrique comprend les étapes suivantes :
- croissance d'une couche d'un alliage d'aluminium localisée au-dessus de ladite couche active à l'exception d'une zone d'ouverture au-dessus de laquelle doit être formé l'un desdits miroirs,
- au moins une reprise d'épitaxie de substrat dopé et
- oxydation latérale de ladite couche d'alliage d'aluminium localisée.

Avantageusement, l'oxydation latérale est précédée d'une étape de gravure latérale permettant de dégager la périphérie de la couche d'alliage d'aluminium et ainsi de faciliter l'oxydation.

Selon un aspect de réalisation, l'alliage d'aluminium est constitué d'arséniure d'aluminium AlAs dont l'oxyde présente les avantages d'être à la fois un isolant électrique et un bon conducteur thermique. En outre, dans le cas d'un substrat en arséniure de gallium, un choix approprié de la composition de l'alliage d'arséniure d'aluminium permet un accord de maille avec le substrat, ce qui facilite les reprises d'épitaxie ultérieures. Grâce au procédé selon l'invention, dans le cas où le substrat est le phosphure d'indium, on pourra aussi utiliser un arséniure de gallium désaccordé sur InP. Avec ce substrat, on pourra aussi utiliser comme alliage l'arséniure d'aluminium et d'antimoine AlAsSb avec une composition qui lui assure un accord de maille avec le phosphure d'indium.

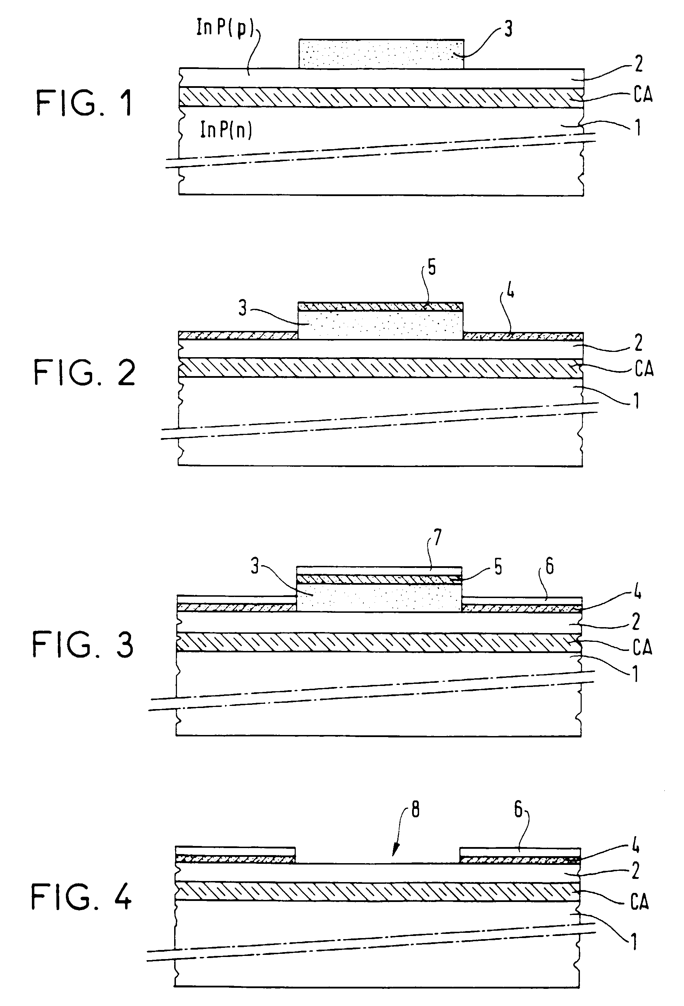

D'autres aspects de l'invention apparaîtront dans la suite de la description en référence aux figures 1 à 6 qui illustrent les principales étapes du procédé selon l'invention.

Les étapes de fabrication qui vont être décrites sont données dans le cas particulier d'un substrat d'InP. Cependant le procédé pourrait être appliqué à tout autre substrat composé d'éléments III-V tel que GaAs.

Comme représenté à la figure 1, on a déposé une couche active CA sur un substrat 1 de phosphure d'indium dopé n. La couche active CA est recouverte d'une couche supérieure de phosphure d'indium dopé p dont l'épaisseur fixera la distance entre la couche active et la couche de confinement électrique. Sur la couche supérieure 2, on a déposé un masque 3 constitué par exemple de silice. La position et les dimensions du masque 3 correspondent à celle de la zone d'ouverture à prévoir dans la couche de confinement électrique.

Comme le montre la figure 2, on dépose ensuite sur la surface du composant une couche d'alliage d'aluminium 4,5. Le dépôt de cette couche peut être réalisé par le procédé d'épitaxie par jet moléculaire ou par dépôt chimique en phase gazeuse d'éléments métallo-organiques (MOCVD). Dans ce dernier cas, la couche d'alliage d'aluminium sera localisée seulement sur les zones où se trouve l'InP.

Conformément à la figure 3, on dépose ensuite une mince couche 6,7 de phosphure d'indium dopée p destinée à ménager une zone de transition dans le cas où l'alliage d'aluminium serait en désaccord de mailles avec le substrat.

On effectue ensuite une gravure humide du masque 3. Dans le cas d'un masque en silice, on utilisera une solution d'attaque à base d'acide fluorhydrique. Cette opération a pour effet de dégager une zone d'ouverture 8 apparaissant à la figure 4.

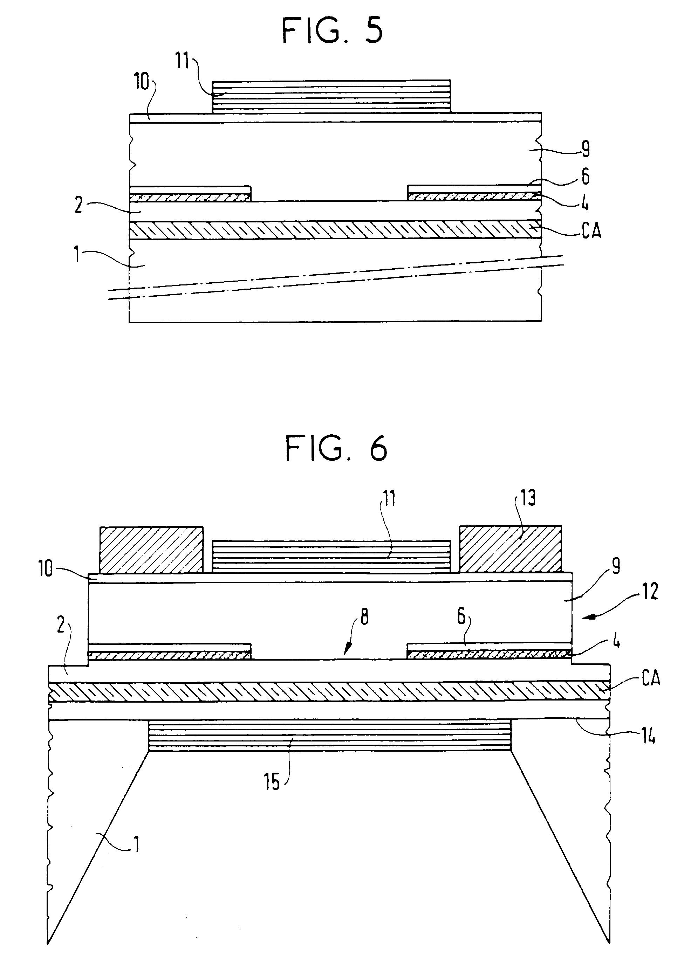

Le procédé se poursuit par une étape de reprise d'épitaxie de phosphure d'indium dopé p pour former une couche de confinement supérieure 9, puis du composé InGaAs pour former une couche de contact 10 (figure 5). Bien qu'on puisse utiliser le procédé d'épitaxie par jet moléculaire, le procédé de dépôt chimique en phase gazeuse d'éléments métallo-organiques (MOCVD) donne de meilleurs résultats du point de vue de la planéité des couches formées. On dépose ensuite le miroir supérieur semi-conducteur ou diélectrique 11.

Comme cela apparaît sur la figure 6, on effectue une gravure latérale de la partie supérieure du composant pour former un mésa 12. La gravure a une profondeur suffisante pour dégager la périphérie de la couche d'alliage d'aluminium 4 et faciliter ainsi son oxydation. On procède alors à l'oxydation latérale de cette couche pour lui conférer sa propriété d'isolant électrique. Pour terminer la fabrication du composant, on effectue ensuite une gravure de la partie inférieure du substrat InP jusqu'à une couche d'arrêt de gravure 14, on forme le miroir inférieur 15 et on place les électrodes 13.

Compte tenu de la faible profondeur de l'ouverture 8, le défaut de planéité des dernières couches 9,10 recevant le miroir 11 peut être considéré comme négligeable. Par ailleurs les contraintes dans la couche 9 au voisinage de la couche d'oxyde 4 n'auront que peu d'effet sur le fonctionnement qui est essentiellement conditionné par la qualité cristallographique de la partie centrale du dispositif.

Quelques données de dimensionnement sont enfin indiquées à titre d'illustration :
- épaisseur de la couche active CA : 0,7 µm
- épaisseur de la couche 4 : 0,2 à 0,3 µm
- distance entre les couches CA et 4 : 1 µm
- diamètre de l'ouverture 8 = 8 µm
- diamètre du miroir 10 = 12 à 16 µm
- diamètre du mésa 11 = 30 µm

La couche active est constituée de l'alliage InGaAsP, avec une composition fonction de la longueur d'onde du laser, par exemple 1,3 ou 1,55 µm.

## Revendications

1. Procédé de fabrication d'un laser semi-conducteur à émission par la surface formé sur un substrat d'éléments III-V, ledit laser comportant une cavité résonnante délimitée par des miroirs (11,15) et contenant une couche active (CA) ainsi qu'une couche de confinement électrique, caractérisé en ce que la formation de ladite couche de confinement électrique comprend les étapes suivantes :
- croissance d'une couche d'un alliage d'aluminium localisée (4) au-dessus de ladite couche active (CA) à l'exception d'une zone d'ouverture (8) au-dessus de laquelle doit être formé l'un desdits miroirs (11),
- au moins une reprise d'épitaxie de substrat dopé (9) et
- oxydation latérale de ladite couche d'alliage d'aluminium localisée (4).

2. Procédé selon la revendication 1, caractérisé en ce que ladite oxydation latérale est précédée d'une étape de gravure latérale permettant de dégager la périphérie (12) de la couche d'alliage d'aluminium (4).

3. Procédé selon l'une des revendications 1 ou 2, caractérisé en ce que ledit alliage d'aluminium est constitué d'arséniure d'aluminium.

4. Procédé selon l'une des revendications 1 ou 2, caractérisé en ce que ledit laser étant formé sur un substrat de phosphure d'indium, ledit alliage d'aluminium est constitué d'arséniure d'aluminium et d'antimoine avec une composition qui lui assure un accord de maille avec le phosphure d'indium.

5. Procédé selon l'une des revendications 1 à 4, caractérisé en ce que la formation de ladite couche d'alliage d'aluminium localisée (4) comprend les étapes suivantes :
- dépôt au-dessus de la couche active (CA) d'un masque (3) dont la position et les dimensions correspondent à ladite zone d'ouverture (8),
- croissance d'une couche d'alliage d'aluminium (4,5) et
- gravure sélective dudit masque (3).

6. Procédé selon la revendication 5, caractérisé en ce que ladite reprise d'épitaxie est effectuée par le procédé de dépôt chimique en phase gazeuse d'éléments métalloorganiques.

7. Procédé selon l'une des revendications 5 ou 6, caractérisé en ce que ladite gravure sélective est précédée d'une étape de dépôt d'une mince couche (6) de substrat dopé.

## Patentansprüche

1. Herstellungsverfahren für einen oberflächenemittierenden Halbleiterlaser, der auf einem Substrat aus Elementen III-V ausgebildet ist,
wobei der Laser einen von Spiegeln (11, 15) begrenzten Hohlraumresonator aufweist und eine aktive Schicht (CA) sowie eine Schicht zur elektrischen Einschließung beinhaltet, dadurch gekennzeichnet, daß die Ausbildung der Schicht zur elektrischen Einschließung die folgenden Schritte umfaßt:
- Wachstum einer lokalisierten Schicht (4) aus einer Aluminiumlegierung über der aktiven Schicht (CA) mit Ausnahme eines Offnungsbereichs (8), über welchem der eine der Spiegel (11) ausgebildet werden muß,
- wenigstens eine Übernahme der Epitaxie des dotierten Substrats (9) und
- seitliche Oxidation der lokalisierten Aluminiumlegierungsschicht (4).

2. Verfahren nach Anspruch 1, dadurch gekennzeichnet, daß der seitliche Oxidation ein Schritt der seitlichen Ätzung vorhergeht, der gestattet, den Umfang (12) der Aluminiumlegierungsschicht (4) freizulegen.

3. Verfahren nach einem der Ansprüche 1 oder 2, dadurch gekennzeichnet, daß die Aluminiumlegierung aus Aluminiumarsenid besteht.

4. Verfahren nach einem der Ansprüche 1 oder 2, dadurch gekennzeichnet, daß der Laser auf einem Substrat aus Indiumphosphid ausgebildet wird, die Aluminiumlegierung aus Aluminiumarsenid und Antimon mit einer Zusammensetzung besteht, die ihr eine Gruppenabstimmung mit dem Indiumphosphid sichert.

5. Verfahren nach einem der Ansprüche 1 bis 4, dadurch gekennzeichnet, daß die Bildung der lokalisierten Aluminiumlegierungsschicht (4) die folgenden Schritte umfaßt:
- Abscheidung einer Maske (3), deren Position und Abmessungen dem Öffnungsbereich (8) entsprechen, über der aktiven Schicht (CA),
- Wachstum einer Aluminiumlegierungsschicht (4, 5) und
- selektive Ätzung der Maske (3).

6. Verfahren nach Anspruch 5, dadurch gekennzeichnet, daß die Epitaxieübernahme durch das Verfahren der chemischen Abscheidung von metallorganischen Elementen in Gasphase erfolgt.

7. Verfahren nach einem der Ansprüche 5 oder 6, dadurch gekennzeichnet, daß der selektiven Ätzung ein Schritt der Abscheidung einer dünnen Schicht (6) von dotiertem Substrat vorhergeht.

## Claims

1. A method of fabricating a surface emitting semiconductor laser formed on a III-V element substrate, said laser including a resonant cavity delimited by mirrors (11, 15) and containing an active layer (CA) and an electrical confinement layer, characterised in that the formation of said electrical confinement layer comprises the following steps:
- growing a localised aluminium alloy layer (4) on top of said active layer (CA) except for an opening area (8) on top of which one of said mirrors (11) is to be formed,
- at least one step of epitaxial regrowth of doped substrate (9), and
- lateral oxidation of said localised aluminium alloy layer (4).

2. A method according to claim 1 characterised in that said lateral oxidation is preceded by a lateral etching step to expose the periphery (12) of the aluminium alloy layer (4).

3. A method according to claim 1 or claim 2 characterised in that said aluminium alloy is aluminium arsenide.

4. A method according to claim 1 or claim 2 characterised in that said laser is formed on an indium phosphide substrate and said aluminium alloy is aluminium and antimony arsenide with a composition such that its lattice matches that of the indium phosphide.

5. A method according to any one of claims 1 to 4 characterised in that the formation of said localised aluminium alloy layer (4) comprises the following steps:
- depositing on top of the active layer (CA) a mask (3) the position and the dimensions of which correspond to said opening area (8),
- growing an aluminium alloy layer (4, 5), and
- selectively etching said mask (3).

6. A method according to claim 5 characterised in that said epitaxial regrowth is effected by the metalorganic chemical vapour deposition process.

7. A method according to claim 5 or claim 6 characterised in that said selective etching is preceded by a step of depositing a thin layer (6) of doped substrate.
